# FASCICULE DE BREVET EUROPEEN

(11) **EP 2 826 078 B1**
(45) Date de publication et mention de la délivrance du brevet: **03.05.2017**
(21) Numéro de dépôt: 13709915.6
(22) Date de dépôt: 15.03.2013
(51) Int. Cl.: H01L 41/187, H01L 41/41, H01L 41/253, C30B 29/30, C30B 33/00, H03H 9/02

(54) **DISPOSITIF A ONDES ACOUSTIQUES COMPRENANT UN MATERIAU DE NIOBATE DE LITHIUM ET/OU DE TANTALATE DE LITHIUM DE COMPOSITION OPTIMISEE A FAIBLE COEFFICIENT TCF ET PROCEDE DE FABRICATION DUDIT MATERIAU**
SCHALLWELLENVORRICHTUNG MIT EINEM LITHIUMNIOBAT- UND/ODER LITHIUMTANTALAT-MATERIAL MIT EINER OPTIMIERTEN LOW-TCF-ZUSAMMENSETZUNG UND VERFAHREN ZUR HERSTELLUNG DIESES MATERIALS
ACOUSTIC WAVE DEVICE COMPRISING A LITHIUM NIOBATE AND/OR LITHIUM TANTALATE MATERIAL WITH AN OPTIMISED, LOW-TCF COMPOSITION, AND METHOD FOR MANUFACTURING SAID MATERIAL

(30) Priorité: 16.03.2012 FR 1252410
(43) Date de publication de la demande: 21.01.2015
(73) Titulaire: Université de Lorraine, 54052 Nancy Cedex (FR)
(72) Inventeur: BARTASYTE, Ausrine, F-57070 Metz (FR); EL MAZRIA, Omar, F-54280 Seichamps (FR)
(74) Mandataire: Esselin, Sophie
(86) Numéro de dépôt international: PCT/EP2013/055454
(87) Numéro de publication internationale: WO 2013/135886

(56) Documents cités:
- US-A- 4 071 396
- US-A1- 2004 145 431
- US-A1- 2006 290 233
- K. YAMADA ET AL: "Characterization of 4-Inch LiTaO<inf>3</inf>Single Crystals for SAW Device Application", IEEE 1984 ULTRASONICS SYMPOSIUM, 1 janvier 1984 (1984-01-01), pages 243-248, XP055050057, DOI: 10.1109/ULTSYM.1984.198298
- AKITSUNA YUHARA ET AL: "PRECISE MEASUREMENT OF LEAKY SAW VELOCITY ON LITAO3-36 YX SUBSTRATES USING A COMB-FILTER METHOD", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 28, no. SUPPL. 28-01, 1 mars 1989 (1989-03-01), pages 114-116, XP000085273, ISSN: 0021-4922
- BARNS R L ET AL: "Lithium tantalate single crystal stoichiometry", JOURNAL OF APPLIED CRYSTALLOGRAPHY, COPENHAGEN, DK, vol. 3, no. 5, 1 octobre 1970 (1970-10-01) , pages 395-399, XP009165971, ISSN: 0021-8898 cité dans la demande
- SUGII K ET AL: "Temperature variations of lattice parameters of LiNbO3, LiTaO3 and Li (Nb 1-y Tay) O3 solid-solutions", JOURNAL OF CRYSTAL GROWTH, ELSEVIER, AMSTERDAM, NL, vol. 33, no. 1, 1 avril 1976 (1976-04-01), pages 199-202, XP024419804, ISSN: 0022-0248, DOI: 10.1016/0022-0248(76)90105-6 [extrait le 1976-04-01]

## Description

Le domaine de l'invention est celui des dispositifs à ondes acoustiques particulièrement intéressants pour fabriquer des filtres à bande étroite ou large bande, des lignes à retard, ou des résonateurs ..., pouvant être utilisés dans des systèmes de télécommunication, et également comme capteurs.

Pour obtenir des dispositifs à ondes acoustiques de qualité, et notamment des dispositifs à ondes acoustiques de surface couramment dénommés « SAW » pour « Surface Acoustic Wave », il est nécessaire de combiner un certains nombre de paramètres dont une grande stabilité de la fréquence de fonctionnement en fonction de la température, un grand coefficient de couplage électromécanique et de faibles pertes de propagation acoustiques.

De manière générale dans les dispositifs à ondes acoustiques de surface, les paramètres suivants ont à être maîtrisés et optimisés :
- la vitesse de propagation de l'onde élastique qui est proportionnelle à la fréquence de fonctionnement et qui définit par conséquent la fréquence maximale de fonctionnement atteignable ;
- le coefficient TCF pour « Temperature coefficient of frequency » qui traduit la variation de la fréquence en fonction de la température. Pour les applications de télécommunication, ce coefficient doit être le plus faible possible pour garantir la stabilité du système quelle que soit la température ambiante ;
- les pertes de propagation acoustiques devant être les plus faibles possibles et le coefficient de couplage électromécanique (K²) devant être le plus grand possible pour assurer une bonne efficacité du dispositif et des pertes d'insertion les plus faibles possible.

Des résultats publiés dans la littérature indiquent que le quartz (coupe ST-X ou LST-X) offre la plus grande stabilité thermique (TCF=0), mais présente en contre-partie un facteur de couplage médiocre. Néanmoins, le quartz peut être préféré pour la réalisation de résonateur où la stabilité est un paramètre crucial. Le niobate de lithium (LN) offre quant à lui les couplages les plus élevés mais au prix d'un coefficient TCF très élevé en valeur absolue de 60 à 95 ppm/°C selon la coupe et la direction de propagation considérées.

Dans les applications de filtrage, les industriels préfèrent l'utilisation du tantalate du lithium (LT) qui offre le meilleur compromis coefficient de couplage électromécanique-coefficient TCF, avec des pertes de propagation élastiques quasi nulles.

Les pistes actuellement investiguées par les chercheurs et industriels travaillant dans le domaine consistent à réduire le coefficient TCF des substrats conventionnellement utilisés par l'ajout de films minces présentant un coefficient TCF de signe opposé. Cette solution efficace pour le coefficient TCF a comme contre-partie l'augmentation des pertes élastiques et la réduction du couplage électromécanique. Un autre inconvénient de la méthode qui frêne son industrialisation est lié à la difficulté de maîtriser avec grande précision l'épaisseur et l'homogénéité du film, la fréquence de fonctionnement du dispositif étant directement influencée par cette épaisseur. Le matériau généralement utilisé pour la compensation de température pour les cristaux de LiNbO₃ et le LiTaO₃ est l'oxyde de silicium (SiO₂) (M. Kadota & T. Kimura, Proceedings of the IEEE Inter. Ultrasonics Sympos. pp 2305-2309 (2006) ; K. Yamanouchi, H. Satoh, T. Meguro, & Y. Wagatsuma, IEEE Trans. Ultras. Ferro. And Freq. Contr. Vol. 42, n°. pp 392-396 (2006). Du fait que le SiO₂ ne présente pas de propriétés piézoélectriques, l'étape de la structuration des électrodes interdigitées (IDTs) doit se faire avant l'ajout de ce film. Il n'est donc pas possible aux industriels des SAW de se procurer des plaquettes déjà compensées en température et doivent disposer sur site de moyens pour l'ajout de ce film.

Le matériau idéal n'existant pas, il est souvent question de trouver le meilleur compromis suivant l'application visée. Typiquement, le tantalate de lithium (coupe 36° Y - direction de propagation X, par définition X correspond à une direction cristallographique <1 1-2 0>, Y- <1 0 -1 0>, et Z - <0 0 0 6> dans la structure définie par le système hexagonal) largement utilisé dans la téléphonie cellulaire comme filtre large bande et il est préféré pour son fort coefficient de couplage (environ 5 %) et des pertes de propagation quasi nulles malgré un coefficient TCF relativement élevé en valeur absolue (35 ppm/°C).

Les matériaux LiTaO₃ et LiNbO₃ sont isomorphes et cristallisent dans le groupe d'espace R3c (comme décrit dans l'article de S.C. Abrahams and J.L.Bernstein, J. Phys. Chem. Solids 28 (1967) 1685-1692, et l'article de S.C. Abrahams, J.M. Reddy, and J.L. Bernstein, J. Phys. Chem. Solids 27 (1966) 997-1012.).

Ces matériaux LiTaO₃ et LiNbO₃ sont isostructuraux et les positions atomiques, les rayons ioniques et les valences de Ta et Nb sont similaires.

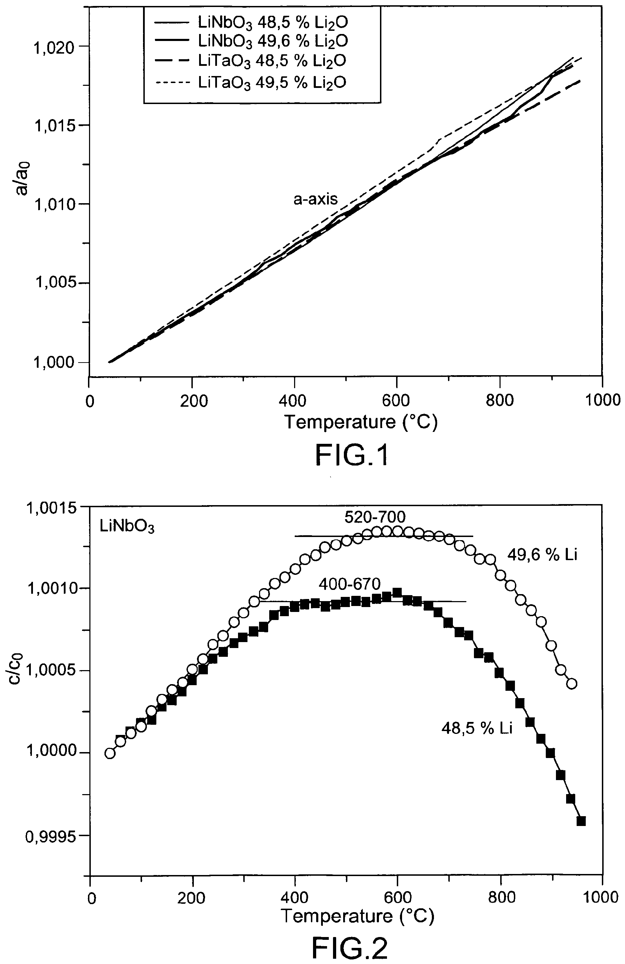

Les deux matériaux ont un paramètre dans le plan basal et une dilatation thermique identiques le long d'un axe a (voir la figure 1 et l'article de K. Sugii, H. Koizumi, S. Miyazawa, S. Kondo, J. Cryst. Growth 33 (1976) 199-202.).

La non-stoechiométrie de Li est typique pour LiTaO₃ et LiNbO₃ comme décrit dans les articles de J.R. Carruthers, G.E. Peterson, M. Grasso and P.M. Bridenbaugh, J. Appl. Phys. 42 (1971) 1846-1851 et de S. Miyazawa, and H. Iwasaki, J. Crystal Growth 10 (1971) 276-278) et la non-stoechiométrie de Li a une influence sur les propriétés structurales et physiques de ces matériaux (voir les articles de M. Wohlecke, G. Corradi, K. Betzler, Appl. Phys. B 63, 323-330 (1996) et de R.L. Barns and J.R. Carruthers, J. Appl. Cryst. 3 (1970) 395).

Actuellement des cristaux de niobate de lithium ou de tantalate de lithium congruents sont commercialisés, ils présentent d'après les auteurs (www.roditi.com) des concentrations respectives en Li₂O de 48,5 % mol, différentes des concentrations stoechiométriques de 50 % mol. Il est à noter que les concentrations du cristal congruent diffèrent d'un auteur à l'autre et suivant la technique utilisée pour la détermination de la composition. Leurs propriétés physiques ne sont pas aussi satisfaisantes que celles des cristaux stoechiométriques (ces derniers présentant des coûts très élevés de fabrication), comme décrit dans l'article de V. Gopalan, V. Dierolf, and D.A. Scrymgeour, Annu.Rev. Mater. Res. 37, 449 (2007).

Le Demandeur est parti du constat que les cristaux de niobate de lithium et de tantalate de lithium existant sous forme du monophase de Li₁₋ₓNb₁₊ₓO_{3+/-δ} ou Li_{1-y}Ta_{1+y}O_{3+/-δ}, présentent un diagramme de phase stable entre les concentrations de Li₂O 46,5 % mol et 51 % mol comme présenté dans l'article L.O. Svassand, M. Eriksrud, G.N. Kenode and A.P. Grande, J. Cryst. Growth, 72, 230 (1974). Les propriétés optiques, mécaniques et les autres propriétés changent continument voire même linéairement dans la plupart des cas, avec la concentration en lithium. Les paramètres, tels que les paramètres de maille, les températures de transition, les coefficients d'expansion thermique sont également dépendants des concentrations en lithium (P.K. Gallagher, H.M. O'Bryan, and C.D. Brandie, Thermochimica Acta 133, 1 (1988), R.L. Barns and J.R. Carruthers, J. Appl. Cryst. 3, 395 (1970)).

La figure 1 montre que la dilatation thermique selon l'axe a (l'axe a correspond à une direction X) est peu sensible à la concentration en lithium dans le cas de différentes concentrations en Li₂O et ce dans le cas de niobate de lithium ou de tantalate de lithium.

La figure 2 illustre quant à elle, l'évolution de paramètre c de maille hexagonale (l'axe c correspond à une direction Z) en fonction de la température, respectivement pour un cristal congruent de niobate de lithium et pour un cristal de niobate de lithium avec 49,6 % mol de Li₂O.

Concernant l'axe c, il apparaît clairement que la dilatation thermique et la température de changement de variation positive en variation négative sont sensibles à la concentration en lithium du cristal considéré.

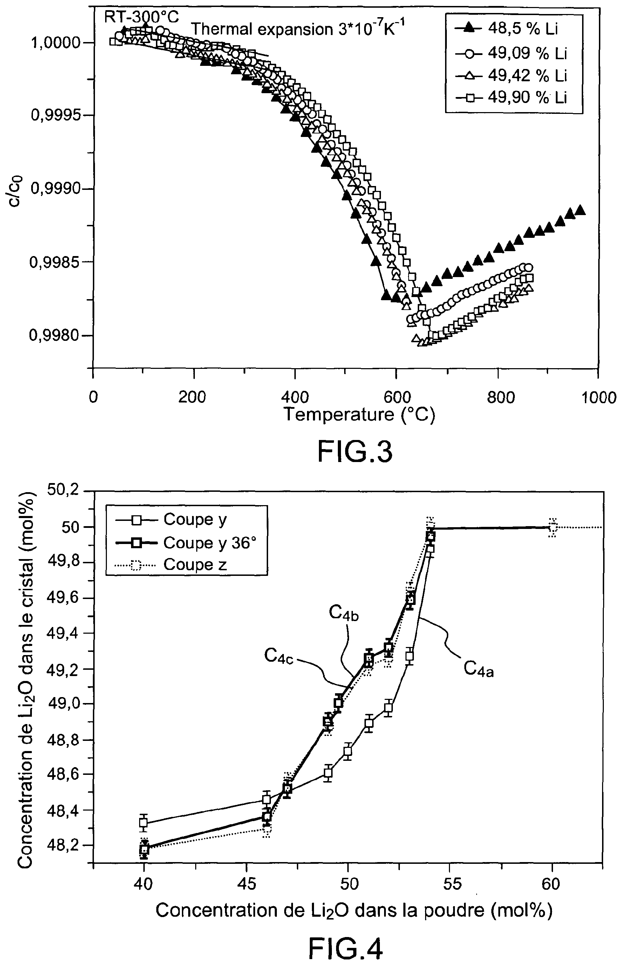

Il est important de noter que la longueur d'axe c passe par un large maximum (correspondant au zéro dilatation thermique selon l'axe c à température ambiante pour LiTaO₃ et à environ 600° C pour LiNbO₃ congruent (K. Sugii, H. Koizumi, S. Miyazawa, S. Kondo, J. Cryst. Growth 33 (1976) 199-202, voir figures 2 et 3), ces températures correspondent aux températures zéro-biréfringence (A.M. Glazer, N. Zhang, A. Bartasyte, D.S. Keeble, S. Huband, P.A. Thomas, J. Appl. Cryst. 43 (2010) 1305-1313) et à des minima observés dans l'évolution de constante élastique C₄₄ en température de LiNbO₃ et LiTaO₃ (I. Tomeno, J. Phys. Soc. Jpn. 52 (1983) 1515.).

Ces points d'inversion peuvent être ajustés en changeant la concentration de Li dans les deux matériaux (voir figure 2 et K. Bastwoste, S. Schwalenberg, Ch. Baumer, E. Kratzig, Phys. Stat. Sol. A 199 (2003) R1-R3).

Ainsi, selon l'axe c, les changements de variation de la dilatation thermique, du positif au négatif, offrent une gamme de températures dans laquelle cette variation de dilatation thermique est très faible ou nulle et peut donc être exploitée. Comme le montre la figure 2, l'expansion thermique selon l'axe c dans le cristal LiNbO₃ congruent est faible sur une plage de 400°C à 650°C ; si la concentration de Li₂O est augmentée jusqu'au 49,6 % mol l'intervalle des températures, correspondantes à une faible expansion thermique, se déplace vers 520 °C - 690 °C.

En faisant varier la concentration du Li on peut ainsi avoir une expansion thermique très faible dans des intervalles très variables.

Le Demandeur considère ainsi que comme le coefficient TCF (temperature coefficient of frequency) est dépendant de l'expansion thermique et de l'évolution des propriétés élastiques avec la température, l'utilisation de la gamme de températures dans laquelle l'expansion thermique est faible permet de diminuer le TCF du LiNbO₃ dans cette gamme de températures. De plus, en changeant la concentration du Li dans le cristal on peut faire varier significativement les propriétés élastiques et donc obtenir la réduction du TCF à la température souhaitée.

Le tantalate de lithium présente également une faible expansion thermique dans la plage de -100°C à 300 °C et peut légèrement varier par le changement de la concentration du lithium dans le cristal comme illustré sur la figure 3.

En outre, cette plage de température peut être réglée pour des applications spécifiques à des températures élevées (entre 400°C et 1000 °C) par modification de la concentration appropriée en lithium dans le cristal de niobate du lithium considéré. Cette plage de température correspondant à une faible expansion thermique peut varier en remplaçant le Nb par du Ta dans le niobate de lithium. Ceci permet d'obtenir des cristaux avec une faible expansion thermique voire nulle sur une large plage de température allant de 200 à 300°C. Cette plage où l'expansion thermique est faible pourra être contrôlée par la composition du cristal et positionnée entre -100 °C et 1000 °C suivant l'application envisagée.

En synthèse, le Demandeur considère que le coefficient TCF peut être réduit sur un intervalle de température, ce qui correspond à une faible dilatation thermique en utilisant des concentrations en lithium dans des matériaux de Niobate de lithium ou de Tantalate de lithium ou des composés mixtes.

Une région à faible dilatation thermique peut notamment correspondre au changement de signe de dilatation thermique de l'axe c du positif au négatif. La largeur de cette région est d'environ 100-300 degrés. Les propriétés élastiques peuvent être modifiées par modification de la concentration de Li dans le tantalate de lithium et le niobate de lithium. La réduction du coefficient TCF peut être obtenue en utilisant une région de faible température d'expansion thermique avec la température / ou de manière appropriée la modification des propriétés élastiques en changeant la concentration de Li.

Les solutions solides LiNb₁₋ₓTaₓO₃ peuvent être utilisées pour ajuster linéairement les propriétés structurales et physiques entre celles de LiNbO₃ et celles de LiTaO₃.

Par exemple, la température de Curie, la biréfringence (I.G. Wood, P. Daniels, R. H. Brown, and A.M. Glazer, J. Phys.: Condens. Matter 20 (2008) 235237), l'évolution de l'axe c en température (K. Sugii, H. Koizumi, S. Miyazawa, S. Kondo, J. Cryst. Growth 33 (1976) 199-202), peuvent être affinées en douceur de LiTaO₃ à LiNbO₃ en remplaçant Ta par Nb.

Ainsi l'intervalle de température dans lequel le coefficient TCF est réduit, peut être réglé de -100°C à 1000°C, par modification de la concentration de Li dans le tantalate de lithium et dans le niobate de lithium, et ce également par dopage de ces cristaux avec des ions métalliques, par le remplacement de Nb par Ta, en utilisant des solutions solides LiNbO₃-LiTaO₃.

Tous ces principes peuvent être appliqués pour des cristaux pauvres en oxygène (noir, gris ou jaune) et des couches minces (S. Jen & R. Bobkowski ; IEEE Intern. Ultrasonics Sympos. pp 269-273 (2000)). Le coefficient TCF réduit à des températures élevées est particulièrement intéressant pour les applications à haute température, tels que les capteurs (pression, gaz, etc...).

Il est important de noter que la réduction du coefficient TCF peut être obtenue non seulement dans la région à faible dilatation thermique, mais à n'importe quelle température en choisissant correctement la concentration de Li pour obtenir les propriétés les plus stables élastiques en fonction de la température ou pour compenser la dilatation thermique par le changement des propriétés élastiques en tant que fonction de la température.

Il est à noter que les variations de la dilatation thermique du niobate de lithium avec des concentrations en lithium autres, que celle du cristal congruent et du cristal stoechiométrique, n'ont pas été publiées. Dans le cas du tantalate de lithium, seules ont été publiées des conclusions sur la dilatation thermique des cristaux congruents (Y.S. Kim and R.T. Smith, J. Appl. Phys. 40, 4837 (1969), H. Iwasaki and H. Toyoda, Japan J. Appl. Phys. 6, 1338 (1967)).

Des autres matériaux, dispositifs, procédés et structures sont décrits par K. Yamada et al., IEEE 1984 Ultrasonics Symposium, p. 243-248, DOI: 10.1109/ ULTSYM.1984.198298, (1984);
et
Yuhara et al., Jap. J. Appl. Phys., vol. 28, suppl. 28-1, p. 114-116
R. L. Barns et al., J. Appl. Cryst., vol. 3, p. 395-399, (1970). Dans ce contexte des connaissances actuelles, le Demandeur propose d'utiliser des matériaux de niobate ou de tantalate de lithium dont les concentrations en lithium sont optimisées, situées entre celles des cristaux congruents et celles des cristaux stoechiométriques de manière à présenter des coefficients TCF faibles, combinés à de forts coefficients de couplage afin d'obtenir des dispositifs à ondes acoustiques performants.

Plus précisément la présente invention a pour objet un dispositif à ondes acoustiques comprenant un matériau piézoélectrique de niobate de lithium et/ou de tantalate de lithium et des électrodes de commande caractérisé en ce que ledit matériau piézoélectrique répond à l'une des compositions suivantes :
- Li₁₋ₓNb₁₊ₓO_{3+/-δ} avec x une fraction molaire telle que
   0.97 ≤ 1-x ≤ 1.02 et δ une fraction molaire faible devant 1 ;
- Li_{1-y}Ta_{1+y}O_{3+/-δ} avec y une fraction molaire telle que
   0.97 ≤ 1-y ≤ 1.02 et δ une fraction molaire faible devant 1 ;
- Li_{1-z}Nb₁₊ₚTa_{1+q} O_{3+/-δ} avec z, p et q des fractions molaires, telles que 0 ≤ 1+p ≤ 1.03 , 0 ≤ 1+q ≤ 1.03 et 0.97 ≤ 1 - z ≤ 1.02 et δ une fraction molaire faible devant 1 ;
- ledit matériau piézoélectrique présentant une valeur absolue de coefficient TCF inférieure à environ 20 ppm/° C.

Selon une variante de l'invention, le matériau piézoélectrique est un cristal.

Selon une variante de l'invention, le matériau piézoélectrique est :
- un cristal de Li₁₋ₓNb₁₊ₓO_{3+/δ} et présente une température de Curie comprise dans l'intervalle de températures [1133 °C ; 1233 °C] à plus ou moins 10°C ou ;
- un cristal de Li_{1-y}Ta_{1+y}O_{3+/-δ} et présente une température de Curie comprise dans l'intervalle de températures [603 °C ; 700 °C] à plus ou moins 10°C ou ;
- un cristal de Li_{1-z}Nb₁₊ₚTa_{1+q} O_{3+/-δ} et présente une température de Curie comprise dans l'intervalle de températures : [603 °C ; 1233 °C] à plus ou moins 10°C.

En effet, la concentration en lithium du cristal ferroélectrique considéré, est directement reliée à sa température de Curie, paramètre plus facilement mesurable précisément et correspondant à la transition de la phase ferroélectrique à la phase paraélectrique. Il est à noter que la fraction molaire du Li₂O [Li] en % mol et la température de Curie (Tc) sont liées par la relation : [Li] = 39.078 + 0.0156 * Tc dans le tantalate du lithium et par
[Li] = 31.505 + 0.015 * Tc dans le niobate du lithium.

Selon une variante de l'invention, le cristal est un cristal de tantalate de lithium dans lequel la fraction molaire y est telle que :
1-y = 0.9864 à plus ou moins 0.0021, le cristal présentant une coupe 36° Y, une température de Curie d'environ 653°C à plus ou moins 20°C et une valeur absolue de coefficient TCF inférieure à environ 7ppm/°C.

Selon une variante de l'invention, ledit cristal présente des lacunes d'oxygène.

Selon une variante de l'invention, ledit cristal est dopé avec des ions métalliques pouvant être de type magnésium, zinc ou zirconium.

Selon une variante de l'invention, le dispositif comprend une structure multi-couches comprenant au moins une couche et/ou un substrat de matériau piézoélectrique.

La présente invention a aussi pour objet un procédé de fabrication d'un matériau piézoélectrique de niobate de lithium et/ou de tantalate de lithium pour réaliser un dispositif à ondes acoustiques selon l'invention, caractérisé en ce qu'il comprend :
- la mise en présence d'une poudre dite d'équilibrage à base d' oxyde de lithium, d'oxyde de niobium et/ou oxyde de tantale de composition déterminée, contenant du niobate de lithium et/ou du tantalate de lithium ;
- le chauffage dans des conditions durée/température prédéterminées de la poudre d'équilibrage avec ladite structure initiale, ladite température étant capable de générer un flux de Li₂O interférant avec ladite structure initiale, de manière à élaborer le matériau piézoélectrique de niobate et/ou de tantalate de lithium de composition adéquate pour assurer une valeur absolue de coefficient TCF inférieure à environ 20 ppm/°C.

Selon une variante de l'invention, le procédé de fabrication d'un matériau piézoélectrique de tantalate de lithium pour réaliser un dispositif à ondes acoustiques est caractérisé en ce que la montée en température est effectuée à une température comprise entre environ 1200°C et 1350°C.

Selon une variante de l'invention, le procédé de fabrication d'un matériau piézoélectrique de niobate de lithium pour réaliser un dispositif à ondes acoustiques est caractérisé en ce que la montée en température est effectuée à une température comprise entre environ 1000°C et 1200 °C.

Il est à noter que le temps de traitement est dépendant de l'épaisseur et la coupe du substrat, typiquement la durée de traitement peut être d'environ 64 heures pour les coupes X, Y, 36° Y et une épaisseur du substrat de 500 micromètres.

Selon une variante de l'invention, la poudre d'équilibrage est réalisée par le mélange de poudres de Li₂CO₃ et de Nb₂O₅ et/ou de Ta₂O₅.

Selon une variante de l'invention, les poudres de Li₂CO₃ et de Ta₂O₅ ou Nb₂O₅ sont préalablement broyées, pressées et portées à une température de frittage puis re-broyées.

Selon une variante de l'invention, ladite structure initiale est un cristal pouvant être un cristal congruent.

L'invention sera mieux comprise et d'autres avantages apparaîtront à la lecture de la description qui va suivre donnée à titre non limitatif et grâce aux figures annexées parmi lesquelles :
- la figure 1 illustre l'évolution du paramètre a (de maille hexagonale), normalisé par rapport à sa valeur à la température ambiante, pour différentes concentrations en lithium dans le cas de niobate de lithium ou de tantalate de lithium ;
- la figure 2 illustre l'évolution du paramètre c (de maille hexagonale), normalisé par rapport à sa valeur à la température ambiante, pour différentes concentrations en lithium dans le cas de niobate de lithium ;
- la figure 3 illustre l'évolution du paramètre c (de maille hexagonale), normalisé par rapport à sa valeur à la température ambiante, pour différentes concentrations en lithium dans le cas du tantalate de lithium;
- la figure 4 illustre l'évolution de la concentration de Li₂O dans les coupes Y, Y36° et Z de cristaux de tantalate de lithium traités à 1250° C pour 64 heures en fonction de la concentration de Li₂O dans la poudre d'équilibrage.

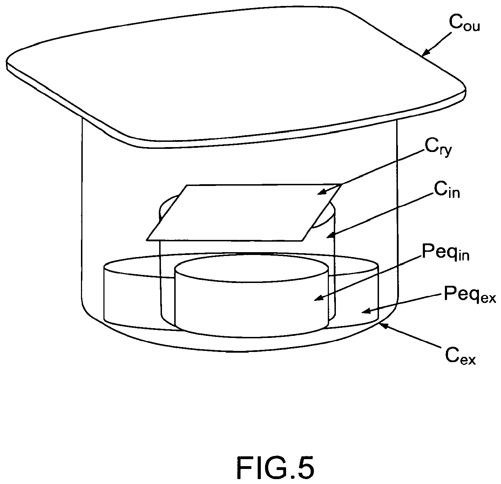

- la figure 5 illustre un exemple de dispositif utilisé pour réaliser les compositions optimisées de matériau piézoélectrique dans un procédé selon l'invention ;

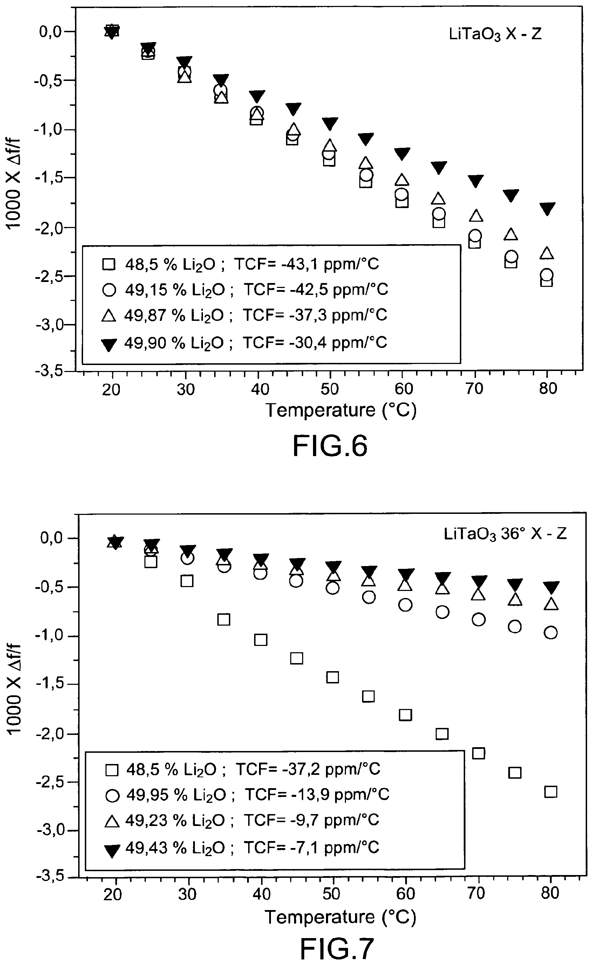

- la figure 6 illustre l'évolution de la fréquence avec la température et la variation du coefficient TCF suite au traitement proposé dans l'invention, pour la propagation d'onde de Rayleigh dans le cas de tantalate de lithium de coupe X, propagation-Z ;
- la figure 7 illustre l'évolution de la fréquence avec la température et variation du TCF suite au traitement proposé dans l'invention, pour la propagation d'onde leacky dans le cas de tantalate de lithium de coupe 36°-Y, propagation selon X.

Dans le cadre de la réalisation d'un dispositif à ondes de surface à base de cristal de tantalate de lithium selon l'invention, le Demandeur a mis en évidence que le coefficient de dilatation thermique du tantalate de lithium selon l'axe c présente une inversion de signe dans une plage de température comprise entre -100°C et 150°C et que ce coefficient peut être réduit à 3.10⁻⁷ K⁻¹ (limité par la résolution de la diffraction des rayons X) dans la gamme de température de -200°C à 300°C en ajustant la concentration en Li₂O de tantalate de lithium avec des concentrations comprises entre 46.5%mol et 51%mol.

Et dans le cristal de niobate de lithium, l'inversion du signe d'expansion thermique se passe entre 500 et 900 °C selon la concentration du lithium. Ceci permet de faire varier la gamme des températures dans laquelle l'expansion thermique est faible, de 300 °C à 1000 °C.

Très peu de données ont été publiées sur la dépendance des propriétés acoustiques et piézoélectriques avec la concentration en Li dans le cristal (A. de Bernabe, C. Prieto, and A. de Andres, J. Appl. Phys. 79, 143 (1996)).

Il y a plusieurs méthodes permettant de changer la concentration de Li dans le cristal, croissance à partir du quasi-flux, « Top seeded solution growth », etc. Holman et al. ont proposé une méthode, nommée « Vapour Transport équilibration » (TEV ou VTE), qui permet d'obtenir une concentration en Li dans les cristaux de tantalate de lithium et de niobate de lithium (R.L. Holman, P.J. Cressman, and J.F. Revelli, Appl. Phys. Lett. 32, 280 (1978), R.L. Holman, United States Patent 4071396 (1978)). Cette méthode est basée sur le traitement d'un substrat de monocristal à haute température (1000°C-1400°C) dans les atmosphères enrichies en Li ou appauvries en Li.

Ces atmosphères sont créées à partir de poudre dites d'équilibrage réalisées à partir de phase dite simple en Li_{1-y}Ta_{1+y}O₃ ou Li₁₋ₓNb₁₊ₓO₃ ou de phase dite double en Li₃TaO₄-LiTaO₃ (ou Li₃NbO₄-LiNbO₃) ou LiTa₃O₈-LiTaO₃, (ou LiNb₃O₈-LiNbO₃) à haute température.

La différence de concentration en Li entre le monocristal et la poudre dite d'équilibrage crée le potentiel chimique qui induit une « in-diffusion » d'ions en Li ou une « out-diffusion » d'ions Li à des températures élevées. En effet, la température doit être suffisamment élevée pour générer la diffusion de Li et la volatilité de Li₂O. Plus la différence de concentration en Li est importante entre la poudre et le cristal et plus l'échange d'ions entre la poudre et le cristal est rapide. Par exemple, en utilisant une poudre avec le ratio Li/(Li+Ta) = 0.6, un cristal congruent de LT devient stoechiométrique au bout d'une durée de 16 heures en étant chauffé à 1250 ° C.

Les travaux expérimentaux du demandeur ont montré qu'en changeant la composition du Li₂O dans la poudre d'équilibrage, comme illustré en figure 4, et la température du procédé, cela permettait d'obtenir des cristaux avec des compositions homogènes et intermédiaires entre celles stoechiométriques et celles congruentes. Il est important de noter que la concentration de Li₂O dans le cristal traité n'est pas égale à la concentration initiale de Li₂O dans la poudre d'équilibrage (voir figure 4).

Plus précisément, la courbe C₄ₐ est relative à la coupe Y, la courbe C_{4b} est relative à la coupe Y 36°, la courbe C_{4c} est relative à la coupe Z.

La concentration de Li₂O dans le cristal traité est définie par la concentration de vapeurs de Li₂O, qui dépend fortement de la température de traitement.

Le tableau A ci-après récapitule la concentration de Li₂O dans la coupe Z des cristaux de tantalate de lithium traités avec la poudre d'équilibrage contenant 50 mol% de Li₂O en fonction de la température et le temps de traitement. (La distribution de Li₂O est homogène dans tous les cristaux).

**Tableau A**

| Température, °C | Temps, h | %Li₂O dans le cristal, mol% |
|---|---|---|
| 1200 | 10 | 48.66 |
| 1250 | 10 | 48.70 |
| 1300 | 10 | 48.79 |
| 1250 | 24 | 48.84 |
| 1250 | 64 | 48.99 |

La concentration de Li₂O et son homogénéité à l'intérieur du cristal traité dépendent aussi de la coupe du cristal (voir figure 4), car la vitesse de diffusion de lithium est différente le long des axes cristallographiques différents (Zhang et al. Cryst. Growth & Design 7 (2007) 1541).

La vitesse de diffusion de Li est supérieure le long de l'axe c à celle le long de l'axe a. Ainsi, des temps de traitement plus courts sont nécessaires pour la coupe Z des cristaux (10 h à 1250 ° C), par rapport à ceux pour la coupe Y des cristaux (48 h à 1250 ° C).

Le temps de traitement permettant d'obtenir les cristaux homogènes dépend aussi de la température de traitement. Une température plus élevée de traitement nécessite des temps plus courts d'homogénéisation. Donc, contrairement à ce qui est affirmé dans la littérature, des temps de traitements plus courts que le temps d'homogénéisation ne permettent pas d'obtenir de cristaux avec des compositions homogènes et intermédiaires. Le traitement du cristal pour un temps plus long que le temps d'homogénéisation, permet néanmoins d'obtenir des concentrations différentes de Li₂O avec une répartition homogène dans les cristaux (Tableau A). Avec un temps de traitement plus long que le temps d'homogénéisation, la concentration de Li₂O dans le cristal peut être également modifiée en changeant la température de traitement (Tableau A), comme les volatilité/concentration vapeur de Li₂O changent sensiblement avec la température.

La composition de la poudre et la température de traitement permettent de contrôler la concentration du lithium dans le cristal et le temps de traitement et l'homogénéité du cristal.

Contrairement à ce qui est affirmé dans la littérature, des temps de traitements plus courts ne permettent pas d'obtenir de cristaux avec des compositions homogènes et intermédiaires.

La méthode de traitement « TEV » sur des cristaux de LN et de cristaux LT, permet ainsi l'adaptation de leur propriétés structurales, de leurs propriétés optiques, élastiques, acoustiques mécaniques et d'autres propriétés physiques en changeant la concentration du Li. Le changement de concentration de Li dans le cristal peut être facilement appliqué industriellement et à faible coût.

La présente invention propose ainsi d'utiliser par exemple le système du double creuset tel qu'illustré en figure 5 : la poudre d'équilibrage est placée dans le creuset interne Cₑₓ (voir Peq ᵢₙ) et autour d'un creuset interne Cᵢₙ dans le creuset externe (voir Peqₑₓ) le cristal C_{ry} pour l'équilibration est placé sur le creuset interne en fermant ce dernier. Le creuset extérieur est enfermé par un couvercle Cₒᵤ.

Cette configuration permet d'obtenir les cristaux avec une composition homogène. Les cristaux homogènes peuvent être obtenus même si le creuset interne est enfermé partiellement par le cristal traité. Les creusets employés peuvent être en Al₂O₃ ou Pt.

Le procédé de la présente invention consiste ainsi à faire subir au substrat à améliorer, un traitement thermique à température élevée, supérieure à 1000°C et dans un environnement convenablement choisi. Ce traitement permet de contrôler l'expansion thermique du matériau qui influence directement le coefficient TCF et les propriétés élastiques et leur dépendance à la température (variation avec la température). Toute la difficulté du procédé est de trouver les bons paramètres du traitement thermique (température et composition chimique de poudre d'équilibrage et durée du traitement) permettant de contrôler l'expansion et les propriétés élastiques préférentiellement suivant un axe cristallographique donné afin d'obtenir le coefficient TCF visé pour une coupe cristallographique donnée pour le tantalate et/ou le niobate de lithium. Ainsi, le procédé de la présente invention, permet de contrôler la stoechiométrie du matériau (niobate ou tantalate de lithium) en l'enrichissant ou en l'appauvrissant en Lithium.

Les substrats enrichis et dont la composition s'approche du celle du cristal stoechiométrique ont conservé toutes leurs propriétés et ont vu leur coefficient TCF décroitre en valeur absolue passant de :
- 32 ppm/°C à 25 ppm/°C pour la coupe Y direction de propagation Z ;
- 43 ppm/°C à 30 ppm/°C pour la coupe X direction de propagation Z ;
- 37 ppm/°C à 7 ppm/°C pour la coupe 36° Y, direction de propagation X.

Les caractérisations fonctionnelles de dispositifs SAW ont donc montré que le procédé de la présente invention permet de faire évoluer les propriétés du matériau dans le sens espéré compte tenu de l'application visée.

### Exemple de procédé de fabrication selon l'invention d'un cristal Li₁₋ₓTa₁₊ₓO₃ pour réaliser un dispositif à ondes acoustiques à faible coefficient TCF :

A partir d'un cristal congruent préalablement élaboré, on fabrique le cristal de matériau recherché dans les bonnes compositions en présence d'une poudre dite d'équilibrage. Cette poudre est élaborée à partir des matières premières suivantes : Li₂CO₃ et Ta₂O₅. Pour ce faire, des poudres de Li₂CO₃ et Ta₂O₅ sont mélangées dans un rapport molaire approprié. Pour exemple, une poudre de Li_{0.98}Ta_{1.02}O₃ est préparée à partir de 49 % molaire du Li₂CO₃ et 51 % mol du Ta₂O₅.

Les poudres sont broyées et mélangées pendant 30 minutes, pressées en des comprimés qui sont alors frittés à 1000°C pendant 48 heures, ensuite rebroyées, comprimés et frittés une seconde fois pendant 72 heures à 1000°C. Les comprimés frittés sont réduits en poudre et mis dans un double creuset (pour exemple d'Alumine (Al₂O₃)). Le cristal congruent de tantalate de lithium est mis en présence de la poudre préconstituée dite d'équilibrage dans un creuset. L'ensemble est chauffé dans des conditions opératoires qui influencent la composition du cristal final. Lors de l'opération de chauffage, la température, la composition de la poudre d'équilibrage et la durée sont des paramètres déterminants. L'élévation de température génère un flux de Li₂O qui vient interférer avec le cristal congruent en modifiant par la même sa composition chimique. L'ensemble est porté à une température d'équilibrage de 1250°C. Dans le cas de poudre monophasée ou biphasée, la concentration finale Li dans le cristal dépend de la teneur en Li dans la poudre d'équilibration. Le temps d'équilibrage est de 64 heures. Après le traitement thermique, la surface du cristal est éventuellement polie. La concentration finale en Li dans le cristal est déterminée par spectroscopie Raman ou par la détermination de la température de Curie. La précision avec laquelle sont obtenues les concentrations est de ±0,08%mol par spectroscopie Raman.

La concentration du lithium peut être estimée à partir de la largeur des modes Raman (tous les modes peuvent être utilisés dans ce but). La température de Curie est quant à elle déterminée avec une précision de ±10°C, ce qui correspond à une précision sur la concentration de 0,15 %mol.

La concentration du lithium dans la profondeur du cristal est estimée en faisant le z-scan par spectroscopie Raman, qui permet d'obtenir les spectres Raman du volume en différentes profondeurs de cristal, (la précision en profondeur est d'ordre de 10 µm). L'analyse précise de la concentration du lithium en profondeur du cristal peut être faite en réalisant les mesures Raman sur la « cross-section » du cristal (résolution latérale d'ordre de 1 µm). Pour réaliser le dispositif à ondes acoustiques de type SAW, on procède à la réalisation, par lithographie et gravure, d'électrodes interdigitées dites IDTs (pour interdigital transducers) de manière connue sur une surface polie de cristal et l'on peut ainsi réaliser des mesures de coefficients TCF.

Pour valider le concept de la présente invention, le Demandeur a considéré deux coupes cristallographiques du tantalate de Lithium à savoir :
- la coupe X direction de propagation suivant Z ;
- la seconde coupe 36°-Y direction de propagation selon X a été choisie parce qu'elle présente de très bonnes propriétés élastiques et notamment un fort couplage électromécanique (5%) quand on considère une onde dite à pertes (leacky wave). Cette coupe est largement utilisée par les industrielles des SAW.

Le coefficient de la variation de la fréquence avec la température (TCF) à été également mesuré. L'augmentation de la concentration de lithium dans le tantalate de lithium a permis de faire passer le TCF de 43 ppm/ °C à 30 ppm/°C en valeur absolue dans la coupe X (propagation selon axe Z) comme le montre la figure 6.

En ce qui concerne le coupe 36° Y - propagation selon X, on remarque que la valeur absolue du TCF a drastiquement diminué suite à l'augmentation de la concentration de lithium dans le tantalate de lithium en passant de 37 ppm/°C (35 ppm/°C d'après la littérature) à 7 ppm/°C comme illustré en figure 7.

De plus, une diminution des pertes d'insertion a été observée dans les cristaux présentant une concentration de lithium supérieure à la concentration congruente (48.5 % mol de Li₂O).

Pour les deux coupes, le Demandeur a réalisé des dispositifs SAW en configuration ligne à retard en structurant des électrodes interdigitées (IDT) sur le substrat de tantalate de lithium à l'aide de la lithographie optique et une gravure humide. Les IDTs sont constituées d'un film d'aluminium d'une épaisseur de 100 nm. Leur période qui définit également la longueur d'onde λ est de 24 µm. Chaque IDT est constituée de 50 paires de doigts.

Les caractéristiques fréquentielles des dispositifs SAW ainsi réalisés ont été déterminées en utilisant un analyseur de réseau et un testeur sous pointe équipé d'un support chauffant avec un système pour le contrôle de la température. Les réponses fréquentielles des SAW ont été alors mesurées en fonction de la température entre 20 et 100°C.

En ce qui concerne la coupe X (propagation Z), le Demandeur a mesuré une fréquence centrale du dispositif à 137 MHz, ce qui correspond à une vitesse de propagation de l'onde de Rayleigh de l'ordre de 3200m/s, valeur conforme aux prédictions théoriques. Le coefficient de la variation de la fréquence avec la température (TCF) à été également mesuré, il est égal à 43.1 ppm/°C en valeur absolue.

Le traitement a permis de réduire ce coefficient jusqu'à 30 ppm/°C en valeur absolue, comme illustré en figure 6 qui montre l'évolution de la fréquence avec la température et la variation du TCF suite au traitement, pour un cristal de tantalate de lithium de coupe X avec propagation selon Z. Il est à noter que la vitesse de propagation n'a été que très sensiblement modifiée (variation < 5%).

Le tableau ci-dessous récapitule les résultats obtenus pour différentes conditions de traitement et fournit la valeur du coefficient TCF mesurée expérimentalement, la vitesse de l'onde élastique de Rayleigh déterminée expérimentalement, la concentration molaire de Li₂O dans des poudres d'équilibrage, utilisés pour le traitement, la température de Curie (Tc) mesurée et la concentration en Li relative déduite ainsi que la concentration du Li déterminée par les moyens de la spectroscopie Raman. La référence correspond à un cristal congruent vendu par www.mtixtl.com.

| | **Référence** | **M26 LT 60 F** | **M 14 LT 60** | **M 15 LT 60** |
|---|---|---|---|---|
| Li₂O %mol dans la poudre d'équilibrage | - | **49.5** | **59.2** | **58** |
| Vitesse élastique (m/s) Rayleigh | **3188** | **3334** | **3289** | **3252** |
| TCF (ppm/°C) | -43.1 | -42.5 | -37.3 | -30.4 |
| Tc de cristal (°C) | 602 | 649 | 698 | 698 |
| Li₂O (% mol) dans cristal à partir du Tc | 48.46 | 49.20 | 49.97 | 49.97 |
| Li₂O (% mol) dans cristal-spectroscopie Raman | 48.5 | 49.15 | 49.87 | 49.90 |

En ce qui concerne la coupe 36° Y - direction de propagation X, on remarque que la valeur absolue du coefficient TCF a drastiquement diminuée suite au traitement en passant de 37 ppm/°C (35 ppm/°C d'après la littérature) à 7 ppm/°C, comme illustré en figure 7 qui montre l'évolution de la fréquence avec la température et la variation du TCF suite au traitement, pour un cristal LT de coupe 36°-Y, pour une propagation selon X, d'onde de leacky.

Le tableau ci-dessous donne la correspondance entre la valeur du TCF mesurée expérimentalement, la vitesse de l'onde élastique de Leacky déterminée expérimentalement, la concentration molaire de Li₂O dans des poudres d'équilibrage, utilisés pour le traitement, la température de Curie (Tc) mesurée et la concentration en Li relative déduite ainsi que la concentration du Li déterminée par les moyens de la spectroscopie Raman. La référence correspond à un cristal congruent vendu par www.mtixtl.com.

| | **Référence** | **M15 LT 60** | **LT 50** | **LT 60A** |
|---|---|---|---|---|
| Li₂O %mol dans la poudre d'équilibrage | - | **57.5** | **49.7** | **49.5** |
| Vitesse élastique (m/s) De l'onde Leacky | **4148** | **4204** | **4043** | **4117** |
| TCF (ppm/C) | -37.2 | -13.9 | -9.7 | -7.1 |
| Tc de cristal (°C) | 603 | 699 | 653 | 653 |
| Li₂O (% mol) dans le cristal à partir de Tc | 48.5 | 50 | 49.26 | 49.26 |
| Li₂O (% mol) dans le cristal - spectroscopie Raman | 48.5 | 49.95 | 49.23 | 49.43 |

Le coefficient TCF dépend de la dilatation thermique le long de la direction de propagation des ondes et de l'évolution de la vitesse des ondes acoustiques en température. La dilatation thermique le long de l'axe a (direction <1 0-1 0> dans les coordonnées hexagonales) dans des cristaux LiTaO₃ est 20,5 ppm / °C et est peu influencée par la non-stoechiométrie de Li tel qu'illustré sur la figure 1.

Le TCF élevé de cristaux Y36°-X LiTaO₃ congruent et non traité est lié à la dépendance négative de la vitesse de propagation le long de l'axe X en fonction de la température. Ainsi, la diminution du TCF (-7 ppm / °C) dans les cristaux Y36°-X LiTaO₃ contenant 49,43 mol% de Li₂O peut être principalement attribuée au changement du signe de l'évolution de la vitesse de l'onde en température (de -16,7 ppm /°C dans les cristaux congruents à + 13,4 ppm /°C dans les cristaux contenant 49,43 mol% de Li₂O dans la gamme de température 20-100°C).

La vitesse de propagation dans les cristaux Y36°-X LiTaO₃ est principalement définie par la constante élastique C₄₄. Ainsi, il est montré que le coefficient C₄₄ constante élastique de LiTaO₃ dépend fortement de la stoechiométrie de Li. En outre, la composition LiTaO₃ 49,43 mol% de Li₂O correspond aux compositions Li₂O de LiTaO₃ ayant zéro biréfringence (inversion du signe de la dilatation thermique de l'axe c à proximité de la température ambiante (K. Bastwoste, S. Schwalenberg, Ch. Baumer, E. Kratzig, Phys. Stat. Sol. A 199 (2003) R1-R3).

Selon la similitude des propriétés structurales et physiques de LiNbO₃ et LiTaO₃, un effet similaire de la non-stoechiométrie de Li sur la constante élastique C₄₄ de LiNbO₃ peut être attendu au moins à des gammes de températures avec une dilatation thermique faible/zéro de l'axe c.

## Revendications

1. Dispositif à ondes acoustiques comprenant un matériau piézoélectrique de niobate de lithium et/ou de tantalate de lithium et des électrodes de commande **caractérisé en ce que** ledit matériau piézoélectrique répond à l'une des compositions suivantes :
- Li_{1.x}Nb₁₊ₓO_{3+/-δ} avec x une fraction molaire telle que :
0.97 ≤ 1-x ≤ 1.02 et δ une fraction molaire faible devant 1 ;
- Li_{1-y}Ta_{1+y}O_{3+/-δ} avec y une fraction molaire telle que :
0.97 ≤ 1-y ≤ 1.02 et δ une fraction molaire faible devant 1 ;
- Li_{1-z}Nb₁₊ₚTa_{1+q} O_{3+/-δ} avec z, p et q des fractions molaires, telles que : 0 ≤ 1 + p ≤ 1.03, 0 ≤1+q ≤ 1.03 et 0.97 ≤ 1- z ≤ 1.02 et δ une fraction molaire faible devant 1 ;
- ledit matériau piézoélectrique présentant une valeur absolue de coefficient TCF inférieure à environ 20 ppm/° C.

2. Dispositif à ondes acoustiques selon la revendication 1, **caractérisé en ce que** le matériau piézoélectrique est un cristal.

3. Dispositif à ondes acoustiques selon la revendication 2, **caractérisé en ce que** le matériau piézoélectrique est :
- un cristal de Li₁₋ₓNb₁₊ₓO_{3+/-δ} et présente une température de Curie comprise dans l'intervalle de températures [1133 °C ; 1233 °C] à plus ou moins 10 °C ou ;
- un cristal de Li_{1-y}Ta_{1+y}O_{3+/-δ} et présente une température de Curie comprise dans l'intervalle de températures [603 °C ; 700 °C] à plus ou moins 10 °C ou ;
- un cristal de Li_{1-z}Nb₁₊ₚTa_{1+q} O_{3+/-δ} et présente une température de Curie comprise dans l'intervalle de températures : [603 °C ; 1233 °C] à plus ou moins 10 °C.

4. Dispositif à ondes acoustiques selon la revendication 3, **caractérisé en ce que** le cristal est un cristal de tantalate de lithium dans lequel la fraction molaire y est telle que 1-y = 0.9864 à plus ou moins 0.0021, le cristal présentant une coupe 36°-Y, une température de Curie d'environ 653°C à plus ou moins 20 °C et une valeur absolue de coefficient TCF inférieure à environ 7ppm/°C.

5. Dispositif à ondes acoustiques selon l'une des revendications 2 à 4, **caractérisé en ce que** ledit cristal présente des lacunes d'oxygène.

6. Dispositif à ondes acoustiques selon l'une des revendications 2 à 5, **caractérisé en ce que** ledit cristal est dopé avec des ions métalliques pouvant être de type magnésium, zinc ou zirconium.

7. Dispositif à ondes acoustiques selon la revendication 1, **caractérisé en ce qu'**il comprend une structure multi-couches comprenant au moins une couche et/ou un substrat de matériau piézoélectrique.

8. Procédé de fabrication d'un matériau piézoélectrique de niobate de lithium et/ou de tantalate de lithium pour réaliser un dispositif à ondes acoustiques selon l'une des revendications 1 à 7, **caractérisé en ce qu'**il comprend :
- la mise en présence d'une poudre dite d'équilibrage à base d'oxyde de lithium, d'oxyde de niobium et/ou d'oxyde de tantale de composition déterminée, avec une structure initiale contenant du niobate de lithium et/ou du tantalate de lithium;
- le chauffage dans des conditions durée/température prédéterminées de la poudre d'équilibrage avec ladite structure initiale, ladite température étant capable de générer un flux de Li₂O interférant avec ladite structure initiale, de manière à élaborer le matériau piézoélectrique de niobate et/ou de tantalate de lithium de composition adéquate pour assurer une valeur absolue de coefficient TCF inférieure à environ 20 ppm/°C.

9. Procédé de fabrication d'un matériau piézoélectrique de tantalate de lithium pour réaliser un dispositif à ondes acoustiques selon la revendication 8, **caractérisé en ce que** ledit chauffage est effectué à une température comprise entre environ 1200°C et 1350°C.

10. Procédé de fabrication d'un matériau piézoélectrique de niobate de lithium pour réaliser un dispositif à ondes acoustiques selon la revendication 8, **caractérisé en ce que** ledit chauffage est effectué à une température comprise entre environ 1000°C et 1200 °C.

11. Procédé de fabrication d'un matériau piézoélectrique de niobate de lithium et/ou de tantalate de lithium pour réaliser un dispositif à ondes acoustiques selon l'une des revendications 8 à 10, **caractérisé en ce que** la poudre d'équilibrage est réalisée par le mélange de poudres de Li₂CO₃ et de Nb₂O₅ et/ou de Ta₂O₅.

12. Procédé de fabrication d'un matériau piézoélectrique de niobate de lithium ou de tantalate de lithium selon l'une des revendications 8 à 11, **caractérisé en ce que** les poudres de Li₂CO₃ et de Ta₂O₅ ou Nb₂O₅ sont préalablement broyées, pressées et portées à une température de frittage puis re-broyées.

13. Procédé de fabrication d'un matériau piézoélectrique de niobate de lithium ou de tantalate de lithium selon l'une des revendications 8 à 12, **caractérisé en ce que** ladite structure initiale est un cristal pouvant être un cristal congruent.

## Patentansprüche

1. Schallwellenvorrichtung, die ein piezoelektrisches Lithium-Niobat- und/oder Lithium-Tantalat-Material und Steuerelektroden umfasst, **dadurch gekennzeichnet, dass** das piezoelektrische Material einer der folgenden Zusammensetzungen entspricht:
- Li₁₋ₓNb₁₊ₓO_{3+/-δ}, wobei x ein Molenbruch ist, so dass:
0,97 ≤ 1-x ≤ 1,02 und δ ein Molenbruch geringfügig vor 1 ist;
- Li_{1-y}Ta_{1+y}O_{3+/-δ}, wobei y ein Molenbruch ist, so dass:
0,97 ≤ 1-y ≤ 1,02 und δ ein Molenbruch geringfügig vor 1 ist;
- Li_{1-z}Nb₁₊ₚTa_{1+q}O_{3+/-δ}, wobei z, p und q Molenbrüche sind, so dass:
0 ≤ 1 + p ≤ 1,03, 0 ≤ 1 + q ≤ 1,03 und 0,97 ≤ 1 - z ≤ 1,02, und δ ein Molenbruch geringfügig vor 1 ist;
- wobei das piezoelektrische Material einen TCF-Koeffizient-Absolutwert kleiner als etwa 20 ppm/°C hat.

2. Schallwellenvorrichtung nach Anspruch 1, **dadurch gekennzeichnet, dass** das piezoelektrische Material ein Kristall ist.

3. Schallwellenvorrichtung nach Anspruch 2, **dadurch gekennzeichnet, dass** das piezoelektrische Material Folgendes ist:
- ein Kristall von Li₁₋ₓNb₁₊ₓO_{3+/-δ} mit einer Curie-Temperatur innerhalb des Temperaturintervalls [1133°C; 1233°C] plus oder minus 10°C oder
- ein Kristall von Li_{1-y}Ta_{1+y}O_{3+/-δ} mit einer Curie-Temperatur innerhalb des Temperaturintervalls [603°C; 700°C] plus oder minus 10°C oder
- ein Kristall von Li_{1-z}Nb₁₊ₚTa_{1+q}O_{3+/-δ} mit einer Curie-Temperatur innerhalb des Temperaturintervalls [603°C; 1233°C] plus oder minus 10°C.

4. Schallwellenvorrichtung nach Anspruch 3, **dadurch gekennzeichnet, dass** der Kristall ein Lithium-Tantalat-Kristall ist, in dem der Molenbruch y so ist, dass 1-y = 0,9864 plus oder minus 0,0021, wobei der Kristall einen Querschnitt 36°-Y, eine Curie-Temperatur um 653°C plus oder minus 20°C und einen TCF-Koeffizient-Absolutwert kleiner als etwa 7 ppm/°C hat.

5. Schallwellenvorrichtung nach einem der Ansprüche 2 bis 4, **dadurch gekennzeichnet, dass** der Kristall Sauerstoffvakanzen hat.

6. Schallwellenvorrichtung nach einem der Ansprüche 2 bis 5, **dadurch gekennzeichnet, dass** der Kristall mit Metallionen dotiert ist, die vom Typ Magnesium, Zink oder Zirkonium sein können.

7. Schallwellenvorrichtung nach Anspruch 1, **dadurch gekennzeichnet, dass** sie eine mehrlagige Struktur umfasst, die wenigstens eine Schicht und/oder ein Substrat aus piezoelektrischem Material umfasst.

8. Verfahren zur Herstellung eines piezoelektrischen Lithium-Niobat- und/oder Lithium-Tantalat-Materials zum Realisieren einer Schallwellenvorrichtung nach einem der Ansprüche 1 bis 7, **dadurch gekennzeichnet, dass** es Folgendes beinhaltet:
- Platzieren eines Äquilibriumpulvers auf der Basis von Lithiumoxid, Nioboxid und/oder Tantaloxid in der Gegenwart einer bestimmten Zusammensetzung, mit einer Anfangsstruktur, die Lithium-Niobat und/oder Lithium-Tantalat enthält;
- Erhitzen, unter vorbestimmten Dauer/Temperatur-Bedingungen, des Äquilibriumpuders mit der Anfangsstruktur, wobei die Temperatur einen Li₂O-Fluss erzeugen kann, der mit der Anfangsstruktur interferiert, um das piezoelektrische Niobat- und/oder Lithium-Tantalat-Material mit einer Zusammensetzung zu gewinnen, die ausreicht, um einen TCF-Koeffizient-Absolutwert von weniger als etwa 20 ppm/°C zu gewährleisten.

9. Verfahren zur Herstellung eines piezoelektrischen Lithium-Tantalat-Materials zum Realisieren einer Schallwellenvorrichtung nach Anspruch 8, **dadurch gekennzeichnet, dass** das Erhitzen bei einer Temperatur zwischen etwa 1200°C und 1350°C erfolgt.

10. Verfahren zur Herstellung eines piezoelektrischen Lithium-Niobat-Materials zum Realisieren einer Schallwellenvorrichtung nach Anspruch 8, **dadurch gekennzeichnet, dass** das Erhitzen bei einer Temperatur zwischen etwa 1000°C und 1200°C erfolgt.

11. Verfahren zur Herstellung eines piezoelektrischen Lithium-Niobat- und/oder Lithium-Tantalat-Materials zum Realisieren einer Schallwellenvorrichtung nach einem der Ansprüche 8 bis 10, **dadurch gekennzeichnet, dass** das Äquilibriumpulver durch Mischen von Li₂CO₃- und Nb₂O₅- und/oder Ta₂O₅-Pulvern realisiert wird.

12. Verfahren zur Herstellung eines piezoelektrischen Lithium-Niobat- oder Lithium-Tantalat-Materials nach einem der Ansprüche 8 bis 11, **dadurch gekennzeichnet, dass** die Li₂CO₃- und Ta₂O₅- oder Nb₂O₅-Pulver zuvor zermahlen, gepresst und auf eine Friteusetemperatur gebracht und dann erneut zermahlen werden.

13. Verfahren zur Herstellung eines piezoelektrischen Lithium-Niobat- oder Lithium-Tantalat-Materials nach einem der Ansprüche 8 bis 12, **dadurch gekennzeichnet, dass** die Anfangsstruktur ein Kristall ist, der ein kongruenter Kristall sein kann.

## Claims

1. An acoustic wave device comprising a piezoelectric lithium niobate and/or lithium tantalate material and control electrodes, **characterised in that** said piezoelectric material corresponds to one of the following compositions:
- Li₁₋ₓNb₁₊ₓO_{3+/-δ} where x is a molar fraction such as:
0.97 ≤ 1-x ≤ 1.02 and δ is a molar fraction weakly before 1;
- Li_{1-y}Ta_{1+y}O_{3+/-δ} where y is a molar fraction such as:
0.97 ≤ 1-y ≤ 1.02 and δ is a molar fraction weakly before 1;
- Li_{1-z}Nb₁₊ₚTa_{1+q}O_{3+/-δ} where z, p and q are molar fractions such as:
0 ≤ 1+p ≤ 1.03, 0 ≤ 1+q ≤ 1.03 and 0.97 ≤ 1-z ≤ 1.02 and δ is a molar fraction weakly before 1;
- said piezoelectric material having an absolute TCF coefficient value less than approximately 20 ppm/°C.

2. The acoustic wave device according to Claim 1, **characterised in that** the piezoelectric material is a crystal.

3. The acoustic wave device according to Claim 2, **characterised in that** the piezoelectric material is:
- an Li₁₋ₓNb₁₊ₓO_{3+/-δ} crystal and has a Curie temperature that comes within the temperature range [1133°C; 1233°C] by more or less 10°C or;
- an Li_{1-y}Ta_{1+y}O_{3+/-δ} crystal and has a Curie temperature that comes within the temperature range [603°C; 700°C] by more or less 10°C or;
- an Li_{1-z}Nb₁₊ₚTa_{1+q}O_{3+/-δ} crystal and has a Curie temperature that comes within the temperature range [603°C; 1233°C] by more or less 10°C.

4. The acoustic wave device according to Claim 3, **characterised in that** the crystal is a lithium tantalate crystal in which the molar fraction is 1-y = 0.9864 by more or less 0.0021, the crystal having a 36°-Y cut, a Curie temperature of approximately 653°C by more or less 20°C and an absolute TCF coefficient value less than approximately 7 ppm/°C.

5. The acoustic wave device according to any of Claims 2 to 4, **characterised in that** said crystal has oxygen deficiencies.

6. The acoustic wave device according to any of Claims 2 to 5, **characterised in that** said crystal is doped with metal ions that can be of the magnesium, zinc or zirconium type.

7. The acoustic wave device according to Claim 1, **characterised in that** it comprises a multi-layered structure comprising at least one layer and/or a substrate of piezoelectric material.

8. A method for manufacturing a piezoelectric lithium niobate and/or lithium tantalate material in order to produce an acoustic wave device according to any of Claims 1 to 7, **characterised in that** it comprises:
- placing a lithium oxide-, niobium oxide- and/or tantalum oxide-based so-called balancing powder of determined composition in the presence of an initial structure containing lithium niobate and/or lithium tantalate;
- heating under predetermined duration/temperature conditions of the balancing powder with said initial structure, said temperature being capable of generating a flow of Li₂O that interferes with said initial structure such as to create the lithium niobate and/or tantalate piezoelectric material with a composition that is adequate to provide an absolute TCF coefficient value less than approximately 20 ppm/°C.

9. The method for manufacturing a piezoelectric lithium tantalate material in order to produce an acoustic wave device according to Claim 8, **characterised in that** said heating is performed at a temperature of between approximately 1200°C and 1350°C.

10. A method for manufacturing a piezoelectric lithium niobate material in order to produce an acoustic wave device according to Claim 8, **characterised in that** said heating is performed at a temperature of between approximately 1000°C and 1200°C.

11. A method for manufacturing a piezoelectric lithium niobate and/or lithium tantalate material in order to produce an acoustic wave device according to any of Claims 8 to 10, **characterised in that** the balancing powder is produced by mixing Li₂CO₃ and Nb₂O₅ and/or Ta₂O₅ powders.

12. A method for manufacturing a piezoelectric lithium niobate and/or lithium tantalate material according to any of Claims 8 to 11, **characterised in that** the Li₂CO₃ and Ta₂O₅ or Nb₂O₅ powders are previously ground, pressed and brought to a sintering temperature, then re-ground.

13. A method for manufacturing a piezoelectric lithium niobate or lithium tantalate material according to any of Claims 8 to 12, **characterised in that** said initial structure is a crystal that can be a congruent crystal.
